Europäisches Patentamt

European Patent Office

Office européen des brevets

(19)

(11) Numéro de publication: **0 131 492**
**B1**

(12) **FASCICULE DE BREVET EUROPÉEN**

(45) Date de publication du fascicule du brevet:
03.02.88

(51) Int. Cl.⁴: **H 05 K 3/40**

(21) Numéro de dépôt: **84401251.8**

(22) Date de dépôt: **18.06.84**

(54) **Support pour composants comportant des plots de connexion et procédé de repérage de ces plots.**

(30) Priorité: **30.06.83 FR 8310912**

(43) Date de publication de la demande:
**16.01.85 Bulletin 85/3**

(45) Mention de la délivrance du brevet:
**03.02.88 Bulletin 88/5**

(84) Etats contractants désignés:
**DE GB NL**

(56) Documents cité:
**DE-A-2 708 776**
**DE-B-1 126 463**
**GB-A-1 380 403**

(73) Titulaire: **THOMSON- CSF, 173, Boulevard Haussmann, F-75379 Paris Cédex 08 (FR)**

(72) Inventeur: **Lacruche, Bernard, THOMSON- CSF SCPI 173, bld Haussmann, F-75379 Paris Cedex 08 (FR)**
Inventeur: **Bonhoure, Françis, THOMSON- CSF SCPI 173, bld Haussmann, F-75379 Paris Cedex 08 (FR)**

(74) Mandataire: **Lepercque, Jean, THOMSON- CSF SCPI 19, avenue de Messine, F-75008 Paris (FR)**

EP 0 131 492 B1

## Description

L'invention concerne un support pour composants, une carte de circuits imprimés par exemple, comportant des plots de connexion et un procédé de repérage de ces plots sur la carte de circuits imprimés.

Selon une technique courante, la connexion d'un composant sur une carte de circuits imprimés se fait à l'aide de broches appartenant au composant, traversant la carte de circuits imprimés par des trous de connexion et par brasage des broches à des plots de connexion situées sur l'autre face de la carte. Les cartes de circuits sont donc percées, aux points de connexion, de trous généralement circulaires.

Les techniques modernes de fabrication utilisent, pour la mise en place des composants, des machines automatiques qui travaillent par repérage en coordonnées rectangulaires. Ces machines, convenablement programmées, ont besoin des coordonnées des points de connexion pour déterminer la situation exacte de chaque composant sur la carte de circuits imprimés. Pour cela, il faut que les points de connexion aient réellement les coordonnées fournies à la machine. Des vérifications doivent donc être faites sur le cliché de fabrication de la carte de circuits imprimés et sur la carte elle-même. Dans le cas de connexion à l'aide de trous de connexion, les techniques de vérification sont connues.

Par contre, selon une technique récente de connexion, les broches des composants ne traversent pas la carte de circuits imprimés mais sont simplement mises en contact avec des plots de connexion dessinés à la surface de la carte et sont brasées à ces plots de connexion. Ces plots de connexion n'ont pas nécessairement une forme circulaire et sont difficilement repérables.

L'invention se propose de résoudre ces difficultés.

L'invention a donc pour objet un support pour composants comportant des plots de connexion disposés sur au moins l'une de ses faces principales ainsi qu'un système de repérage par coordonnées, caractérisée en ce que le plot de connexion comporte sur sa périphérie au moins deux repères possédant chacun un profil anguleux déterminant un point de repérage, chacun des deux points de reperage ayant des coordonnées différentes dans le système de repérage par coordonnées, le croisement de deux axes parallèles aux axes du système de coordonnées et passant par les deux points de repérage détermine un point de référence du plot de connexion.

L'invention a également pour objet un procédé de repérage des plots de connexion sur un support pour composants caractérisé en ce qu'il comprend les étapes suivantes:

a/ mise en place des plots de connexion, tels que définis précédemment sur une face principale d'une carte de circuits imprimés, de telle façon que les repères soient disposés selon un arrangement déterminé,

b/ fabrication d'une mire de traits perpendiculaires et équidistants correspondant à l'arrangement déterminé,

c/ superposition de la mire et de la carte de circuits imprimés pour vérifier que chaque repère est disposé selon un trait horizontal ou vertical de la mire.

L'invention sera mieux comprise et d'autres caractéristiques et avantages apparaîtront à l'aide de la description qui suit en référence aux figures annexées parmi lesquelles:

- la figure 1 illustre un système de repérage de connexions d'un composant sur une carte de circuits imprimés selon l'art connu;

- la figure 2 représente, en vue de coupe, la connexion du composant de la figure 1;

- la figure 3 illustre un moyen de contrôle de position, sur un cliché, d'un trou de connexion de la figure 1;

- la figure 4 illustre un moyen de contrôle de position d'un trou de connexion sur une carte de circuits imprimés selon l'art connu;

- la figure 5 illustre un mode de connexion selon une technique récente;

- la figure 6 représente un exemple de plot de connexion selon l'invention;

- la figure 7 représente différentes autres formes de plots selon l'invention;

- la figure 8 illustre un moyen de contrôle des positions de plots de connexion selon l'invention sur un cliché ou sur une carte de circuits imprimés;

- la figure 9 représente le plateau d'une machine de mise en place de composants sur une carte de circuits imprimés.

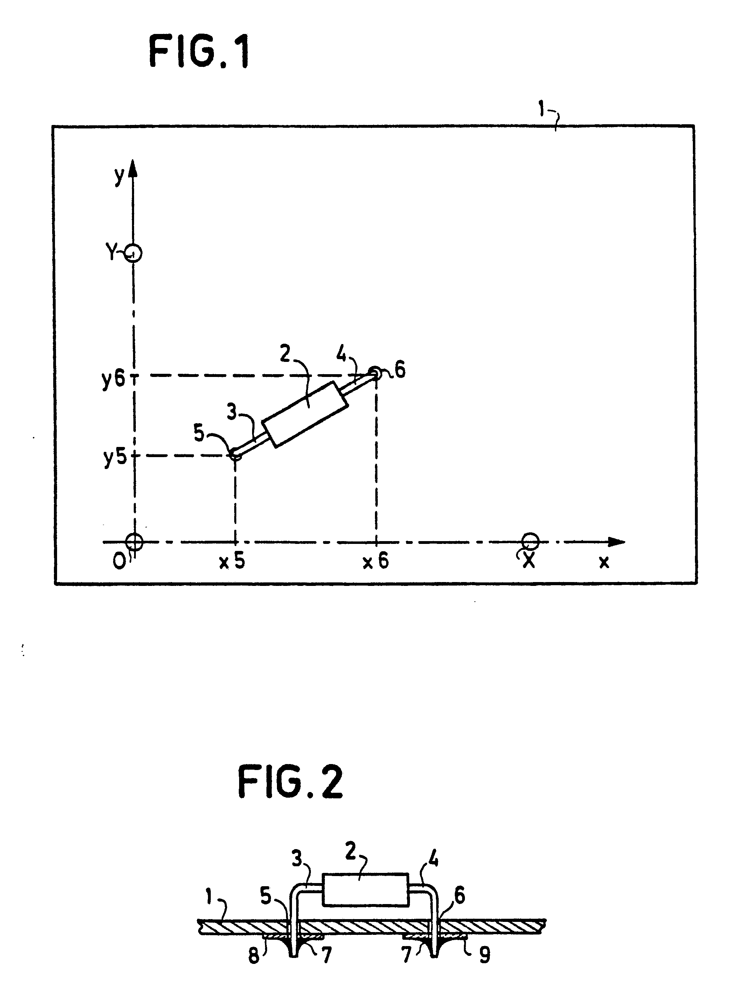

Selon l'art connu, une carte de circuits imprimés comporte des moyens de repérage des points de connexion des composants. La carte 1 représentee par la figure 1 comporte ainsi trois trous O, X et Y qui définissent deux axes de coordonnées Ox et Oy à partir desquels il est aisé de se référer pour déterminer l'abcisse et ordonnée de chaque point de la carte.

Sur la carte 1 est monté un composant 2 possédant deux broches de connexion 3 et 4. Celles-ci traversent la carte 1 et sont connectées de l'autre côté de la carte à des plots de connexion 8 et 9 appartenant à la carte par des points de soudure tels que 7.

Les centres des trous 5 et 6 sont repérés par rapport aux axes de coordonnees Ox et Oy par leurs abscisses respectives x5 et x6 et leurs ordonnées y5 et y6. Pour la mise en place des composants, la carte est calée à l'aide des trous O, X et Y dans une position déterminée sur le plateau d'une machine, de telle manière que connaissant les coordonnées des points de connexion, la machine convenablement programmée puisse placer aisément le composant sur la carte. Cette mise en place est tributaire de la précision du repérage en coordonnées des trous 5 et 6. Il est donc prévu des contrôles aussi bien des clichés photographiques de réalisation des cartes de circuits imprimés, que des cartes elles-mêmes.

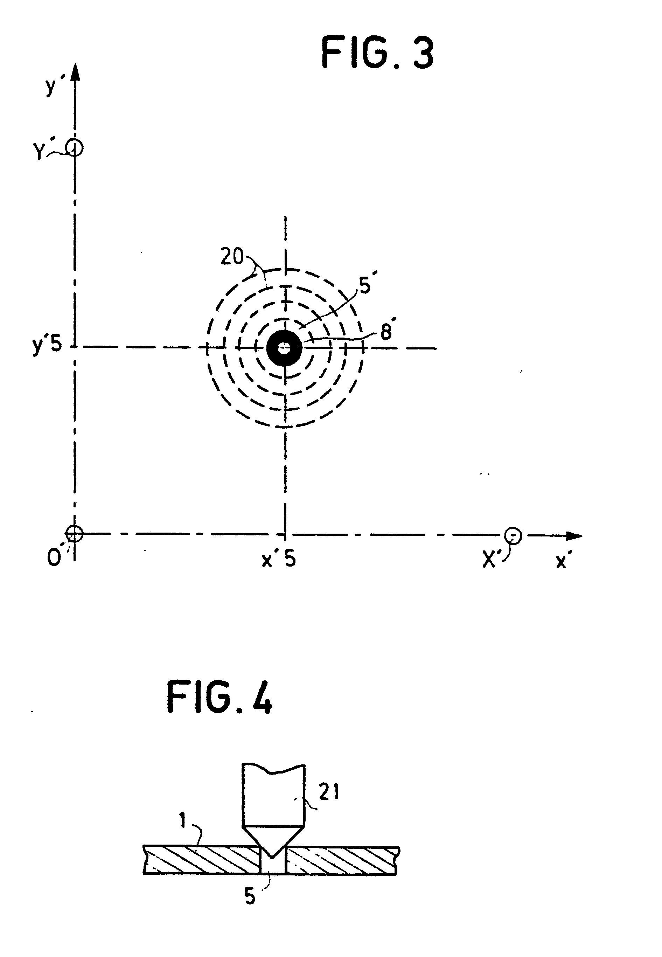

Pour le contrôle des clichés on peut utiliser un réticule. On projette l'image du cliché sur un écran et on superpose un réticule, ou bien on projette l'image superposée du cliché et du réticule. L'image obtenue est du type représenté en figure 3 où l'on trouve l'image du cliché 1', des trous de référence O', Y', X', des trous tel que 5', des plots de connexion tel que 8', ainsi que l'image du réticule 20 représentée en pointillé et constituée de deux traits en croix et de cercles concentriques. Il est aisé en déplaçant le réticule 20 de mesurer les coordonnées d'un trou (x'5 et y'5 pour le trou 5 par exemple) par rapport aux axes de coordonnées O'x' et O'y' ainsi que les distances entre deux trous quelconques.

Le contrôle d'une carte de circuits imprimés peut se faire de façon analogue, en utilisant, par exemple, une pige 21 à embout conique que l'on centre sur le trou 5 à contrôler comme représentée en figure 4. Le déplacement de cette pige selon les axes de coordonnées Ox et Oy, de la même façon que précédemment avec le réticule, permet d'effectuer les mêmes mesures. Il est bien évident que si le contrôle de la carte est effectué avant perçage le contrôle peut se faire à l'aide d'un réticule comme pour les clichés.

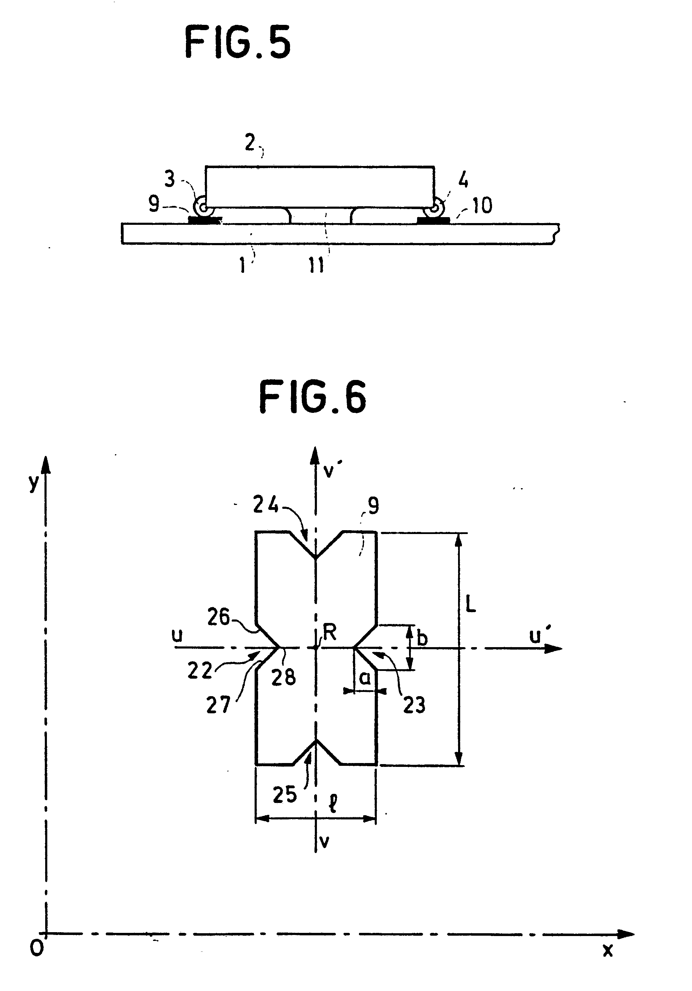

Par contre, selon une technique récente, certains composants sont prévus pour être posés sur la carte de circuits imprimés puis brasés celà sans insertion de broches de connexion. La figure 5 fournit une représentation simplifiée d'un tel composant. Le composant 2 possède des plots de sortie 3 et 4 qui font saillie. Ce composant est placé sur la carte de circuits imprimés 1 de façon que les plots de sortie 3 et 4 reposent sur des plots de connexion 9 et 10 de la carte auxquels ils seront brasés. Par ailleurs, une embase 11 venant en contact avec la carte 1 permet de fixer par collage le composant sur la carte avant l'opération de brasage.

Les plots de connexion ne sont pas nécessairement circulaires et présentent des difficultés de repérages par rapport aux axes de coordonnées de la carte. L'invention se propose donc de résoudre ces difficultés et fournit une carte de circuits imprimés possédant des plots de connexion adaptés à ce type de connexion.

Sur la figure 6, fournissant un exemple de réalisation de l'invention, le plot de connexion 9 a une forme générale rectangulaire. Les côtés du plot 9 possèdent des encoches 22, 23 et 24, 25 en forme de Vé. L'encoche 22, par exemple, possède deux côtés 26 et 27 se coupant en un point 28 qui détermine un point de repérage de la plage de connexion. Il en est de même pour les autres encoches. Les points de repérage des encoches 22 et 23 sont sur un axe uu' parallèle à l'axe de coordonnée Ox et les points de repérage des encoches 24 et 25 sont sur un axe vv' parallèle à l'axe Oy. Le point de croisement R des axes uu' et vv' est le point de référence du plot de connexion.

La visée de ces points de repérage permet ainsi de situer le plot de connexion 9 par rapport aux axes de coordonnées Ox et Oy définis comme précédemment par des trous O, X, Y.

De plus, le fait de prévoir les encoches sur le pourtour du plot de connexion permet d'obtenir un plot de connexion exempt d'impuretés. Celà ne serait pas le cas si on avait choisi de placer un point repère vers le centre du plot faisant courir alors le risque d'enfermer des impuretés ou des gaz dans le plot lors de la soudure.

A titre d'exemple, en fonction de la conception actuelle des composants, un tel plot pourra avoir pour largeur $l = 1,2$ mm, pour longueur $L = 2,2$ mm, pour profondeur d'encoche $a = 0,15$ mm et pour largeur d'encoche $b = 0,2$ mm.

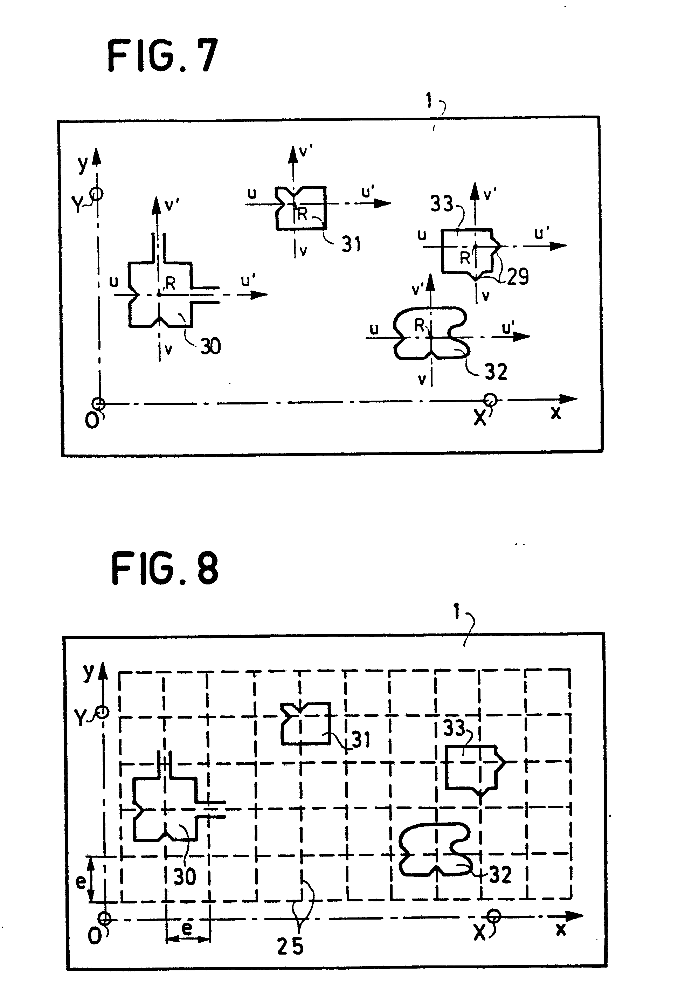

Sur la figure 7, on a représenté, une carte de circuits imprimés 1 avec différentes autres formes des plots conformes à l'invention.

A la différence des plots de la figure 6, chacun de ces plots ne comportent que deux encoches ayant des abscisses et des ordonnées différentes par rapport aux axes Ox et Oy. Ils sont situés chacun sur un axe (uu', vv') parallèles chacun à un axe de coordonnée (Ox, Oy) ce qui suffit pour repérer les plots et déterminer le point de référence R de chaque plot.

Les plots de connexion 30 et 31 possèdent des conducteurs situés sur les axes uu' et vv' ce qui conduit à ne prévoir que deux encoches.

Le plot de connexion 32 a une forme irrégulière qui rend difficile de placer plus de deux repères.

Le plot 33 a été muni de repères constitués de protubérances au lieu d'encoches. Ces protubérances sont conçues, comme les encoches, de deux traits rectilignes se coupant en un point qui termine un point de repérage.

Les plots 31, 32 et 33 font apparaître que les axes uu' et vv' sur lesquels sont placés leurs points de repérage ne passent pas nécessairement par le centre des plots. Celà va être mis à profit pour déterminer l'emplacement des points de repérage sur chaque plage. En effet selon l'invention, on détermine une grille régulière constituée de lignes horizontales, de lignes verticales espacées les unes des autres d'une distance e. Cette grille étant placée sur le dessin du circuit imprimé, on place les plots et les points de repérage pour que les axes uu' et vv' de chaque plot coïncident respectivement avec une ligne horizontale et une ligne verticale de la grille.

De cette façon, que ce soit pour vérifier le cliché photographique de la carte de circuits imprimés ou la carte elle-même, on utilise une mire constituée de traits verticaux et de traits horizontaux espacés de la distance e et on vérifie que les points de repérage sont situés sur les lignes de la mire. Par exemple, en superposant à la carte de la figure 7 une mire 25 ainsi décrite, on obtient l'image de la figure 8.

A titre indicatif, dans l'état actuel de la technique, on prendra $e = 1,27$ mm.

Il est à noter qu'on a choisi, dans l'exemple de réalisation décrit, un système de repérage par rapport à des axes de coordonnées (Ox et Oy) perpendiculaires. Il est bien évident que ces axes pourraient ne pas être perpendiculaires ou que le système de repérage pourrait être un tout autre système de repérage connu (coordonnées polaires, par exemple).

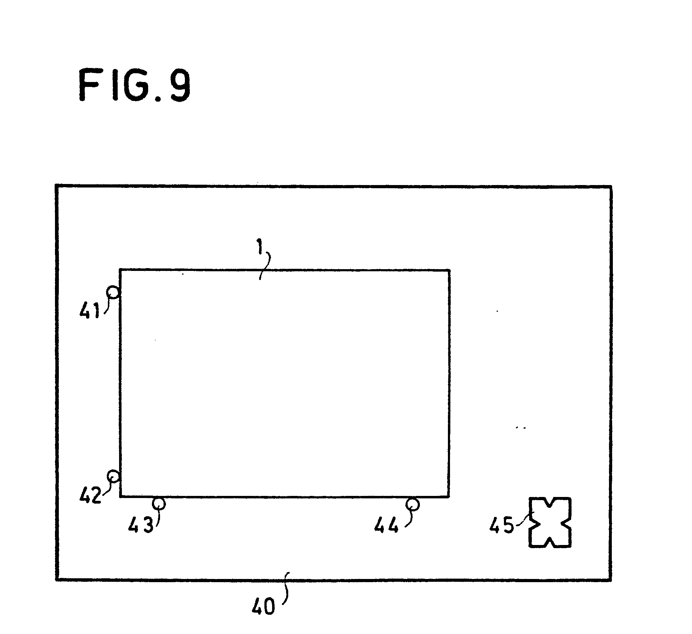

Comme expliqué précédemment, pour la mise en place des composants sur une carte de circuits imprimés, la carte est calée dans une position déterminée, par rapport à des axes de coordonnées sur le plateau d'une machine. C'est ainsi, par exemple, que sur la figure 9, un plateau de machine 40 possède des butées 41, 42, 43, 44. La carte de circuits imprimés 1 est posée à plat sur le plateau 40 en appui contre les butées 41 à 44. La machine convenablement programmée peut ainsi mettre en place les composants aux emplacements désirés.

De plus, à la surface du plateau 40 est dessiné l'image 45 d'un plot de connexion possédant des repères selon l'invention ce qui fournit un élément de contrôle fixe et permet, quand cela est utile de vérifier le bon fonctionnement du système de repérage de la machine.

## Revendications

1. Support (1) pour composants (2) comportant des plots de connexion (9, 30-33) disposés sur au moins l'une de ses faces principales ainsi qu'un système de repérage par coordonnées (O, X, Y) caractérisé en ce que chaque plot de connexion comporte sur sa périphérie au moins deux repéres (22, 24) possédant chacun un profil anguleux déterminant un point de repérage (28), chacun des deux points de repérage ayant des coordonnées différentes dans le système de repérage par coordonnées, le croisement de deux axes parallèles aux axes du système de coordonnées et passant par les deux points de repérage détermine un point (R) de référence du plot de connexion.

2. Support pour composants selon la revendication 1, caractérisé en ce que chaque repère est constitué d'une entaille (22) pratiquée sur la périphérie d'un plot de connexion et déterminant un point de repérage (28).

3. Support pour composants selon la revendication 2, caractérisé en ce que chaque entaille (22) comporte deux parties rectilignes (26 et 27) se coupant en un point (28) qui constitue un point de repérage.

4. Support pour composants selon la revendication 1, caractérisé en ce que chaque repère est constitué d'une saillie (29) prolongeant un plot de connexion sur sa périphérie et dans son plan.

5. Support pour composants selon la revendication 4, caractérisé en ce que chaque saillie (29) comporte deux parties rectilignes se coupant en un point qui constitue un point de repérage.

6. Support pour composants selon la revendication 1, comportant plusieurs plots de connexion caractérisé en ce que les repères sont disposés selon une disposition matricielle, l'un des repères de chaque plot étant disposé selon une ligne de la matrice et l'autre repère, selon une colonne.

7. Procédé de repérage des plots de connexion sur un support pour composants, caractérisé en ce qu'il comprend les étapes suivantes:

a/ mise en place des plots de connexion, tels que définis dans les revendications 1 à 6, sur une face principale d'une carte de circuits imprimés, de telle façon que les reperes soient disposés selon un arrangement déterminé.

b/ fabrication d'une mire de traits perpendiculaires et équidistants correspondant à l'arrangement déterminé.

c/ superposition de la mire et de la carte de circuits imprimés pour vérifier que chaque repère est disposé selon un trait horizontal ou vertical de la mire.

8. Procédé de repérage selon la revendication 7, caractérisé en ce que l'arrangement déterminé est un arrangement matriciel.

## Patentansprüche

1. Träger (1) für Bauteile (2) mit Anschlußpunkten (9, 30-33), die auf mindestens einer der Hauptoberflächen liegen, sowie System zur Ermittlung ihrer Koordinaten (O, X, Y), dadurch gekennzeichnet, daß jeder Anschlußpunkt auf seinem Umfang mindestens zwei Markierungen (22, 24) besitzt, die je ein Winkelprofil zur Bestimmung eines Bezugspunkts (28) aufweisen, wobei jeder der beiden Bezugspunkte andere Koordinatenwerte in dem Bezugskoordinatensystem besitzt, und daß der Kreuzungspunkt von zwei zu den Achsen des Koordinatensystems parallelen Achsen, die durch die Bezugspunkte verlaufen, einen Referenzpunkt (R) des Anschlußpunkts bestimmt.

2. Träger für Bauteile nach Anspruch 1, dadurch gekennzeichnet, daß jede Markierung von einer Einkerbung (22) gebildet wird, die sich am Umfang eines Anschlußpunkts befindet und einen Bezugspunkt (28) bestimmt.

3. Träger für Bauteile nach Anspruch 2, dadurch gekennzeichnet, daß jede Einkerbung (22) zwei geradlinige Bereiche (26, 27) besitzt, die sich in einem einen Bezugspunkt bildenden Punkt (28) schneiden.

4. Träger für Bauteile nach Anspruch 1, dadurch gekennzeichnet, daß jede Markierung von einem Vorsprung (29) gebildet wird, der einen Anschlußpunkt auf seinem Umfang und in seiner Ebene verlängert.

5. Träger für Bauteile nach Anspruch 4, dadurch gekennzeichnet, daß jeder Vorsprung (29) zwei geradlinige Bereiche aufweist, die sich in einem einen Bezugspunkt bildenden Punkt schneiden.

6. Träger für Bauteile nach Anspruch 1, der mehrere Anschlußpunkte aufweist, dadurch gekennzeichnet, daß die Markierungen gemäß einer Matrixanordnung angeordnet sind, wobei eine der Markierungen jedes Anschlußpunkts gemäß einer Zeile der Matrix und die andere gemäß einer Spalte angeordnet sind.

7. Verfahren zur Ermittlung der Anschlußpunkte auf einem Träger für Bauteile, dadurch gekennzeichnet, daß es die folgenden Schritte umfaßt:

a/ Anordnung der Anschlußpunkte wie in den Ansprüchen 1 bis 6 angegeben, auf einer Hauptoberseite einer Druckschaltungskarte, derart, daß die Markierungen gemäß einer bestimmten Verteilung angeordnet sind,

b/ Herstellung eines Rasters senkrechter und äquidistanter Striche gemäß der gegebenen Verteilung,

c/ Überlagerung des Rasters und der Druckschaltungskarte, um zu überprüfen, ob jede Markierung gemäß einem waagerechten und einem senkrechten Strich des Rasters ausgerichtet ist.

8. Ermittlungsverfahren nach Anspruch 7, dadurch gekennzeichnet, daß die gegebene Verteilung eine Matrixverteilung ist.

## Claims

1. A board (1) for components (2) comprising connection studs (9, 30 to 33) arranged on at least one of its main surfaces as well as a coordinate system (O, X, Y) for defining the positions of these studs, characterized in that each connection stud comprises on its periphery at least two marks (22, 24) each having an angle profile determining a marking point (28) each one of the two marking points having different coordinates in the coordinate system, the cross point of two axes which are parallel to the axis of the coordinate system and which pass through the two marking points determining a reference point (R) of the connection stud.

2. A board for components according to claim 1, characterized in that each mark is constituted by a notch (22) cut into the periphery of a connection stud and determining a marking point (28).

3. A board for components according to claim 2, characterized in that the notch (22) comprises two rectilinear portions (26 and 27) which intersect in a point (28) which constitutes a marking point.

4. A board for components according to claim 1, characterized in that each mark is constituted by a protuberance (29) extending a connection stud on its periphery and in its plane.

5. A board for components according to claim 4, characterized in that each protuberance (29) comprises two rectilinear portions which intersect at a point which constitutes a marking point.

6. A board for components according to claim 1, comprising several connection studs, characterized in that the marks are disposed according to a matrix disposition, one of the marks of each stud being disposed along a line of the matrix and the other along a column.

7. A method for retrieving the connection studs on a component board, characterized in that it comprises the following steps:

a/ locating the connection stud as defined in claims 1 to 6 on a main surface of a printed circuit card such that the marks are disposed in accordance with a predetermined arrangement,

b/ manufacturing of a grid of perpendicular and equidistant lines corresponding to the predetermined arrangement,

c/ superposition of the grid and the printed circuit cards for verifying that each mark is disposed in accordance with a horizontal or a vertical grid line.

8. A retrieval method according to claim 7, characterized in that the predetermined arrangement is a matrix arrangement.

# FIG.1

# FIG.2

# FIG. 3

# FIG. 4

# FIG.5

# FIG.6

# FIG. 7

# FIG. 8

# FIG.9